# EUROPÄISCHE PATENTANMELDUNG

(11) **EP 1 132 958 A2**
(43) Veröffentlichungstag der Anmeldung: **12.09.2001**
(21) Anmeldenummer: 01103352.9
(22) Anmeldetag: 13.02.2001
(51) Int. Cl.: H01L 21/8242, H01L 27/108

(54) **Speicherzelle mit Graben und Verfahren zu ihrer Herstellung**

(30) Priorität: 07.03.2000 DE 10011889
(71) Anmelder: Infineon Technologies AG, 81669 München (DE)
(72) Erfinder: Weis, Rolf, 01099 Dresden (DE)
(74) Vertreter: Fischer, Volker, Dipl.-Ing.

(57) **Zusammenfassung**

Die Erfindung betrifft eine Speicherzelle (1), die einen Graben (3) aufweist. In dem Graben (3) ist ein Grabenkondensator angeordnet. Weiterhin ist in dem Graben (3) ein vertikaler Transistor oberhalb des Grabenkondensators gebildet. Zum Anschluß des Gate-Materials (23) des vertikalen Transistors an eine Wortleitung (24) ist ein dielektrische Schicht (12) mit einer Innenöffnung (13) in dem Graben (3) oberhalb des Gate-Materials (23) vorgesehen, die als dielektrischer Ring ausgebildet ist. Der dielektrische Ring ermöglicht einen selbstjustierten Anschluß der Wortleitung (24) an das Gate-Material (23) des vertikalen Transistors.

## Beschreibung

Die vorliegende Erfindung betrifft eine Speicherzelle mit einem Graben, der in einem Substrat gebildet ist. Der Graben ist dazu geeignet, einen Grabenkondensator und einen vertikalen Transistor oberhalb des Grabenkondensators in dem Graben anzuordnen

Speicherbauelemente, wie z.B. DRAMs (dynamic random access memories) bestehen aus einem Zellenfeld und einer Ansteuerungsperipherie, wobei in dem Zellenfeld einzelne Speicherzellen angeordnet sind.

Ein DRAM-Chip hält eine Matrix von Speicherzellen, welche in Form von Zeilen und Spalten angeordnet sind und von Wortleitungen und Bitleitungen angesteuert werden. Das Auslesen von Daten aus den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Transistor. Der Transistor besteht unter anderem aus zwei Diffusionsgebieten, welche durch einen Kanal von einander getrennt sind, der von einem Gate gesteuert wird. Abhängig von der Richtung des Stromflusses wird ein Diffusionsgebiet als Drain-Gebiet und das andere Diffusionsgebiet als Source-Gebiet bezeichnet.

Eines der Diffusionsgebiete ist mit einer Bitleitung, das andere Diffusionsgebiet mit dem Kondensator und das Gate mit einer Wortleitung verbunden. Durch Anlegen geeigneter Spannungen an das Gate wird der Transistor so gesteuert, dass ein Stromfluß zwischen den Diffusionsgebieten durch den Kanal ein- und ausgeschaltet wird.

Durch die fortschreitende Miniaturisierung von Speicherbauelementen wird die Integrationsdichte kontinuierlich erhöht. Die kontinuierliche Erhöhung der Integrationsdichte bedeutet, dass die pro Speicherzelle zur Verfügung stehende Fläche immer weiter abnimmt.

Um die zur Verfügung stehende Fläche effektiv auszunutzen kann der Ausfalltransistor als vertikaler Transistor in einem Graben oberhalb eines Grabenkondensators gebildet werden. Eine Gattungsbildende Speicherzelle mit einem Grabenkondensator und einem vertikalen Transistor in der Druckschrift US 5,744,386 beschrieben. Weitere Ausführungen zu Grabenkondensatoren oder Transistoren sind in den US-Patenten 5,177,576; 5,937,296; 5,977,579; und 5,208,657 beschrieben. Es besteht allerdings bei den genannten Varianten das Problem, das Gate des vertikalen Transistors an eine Wortleitung anzuschließen und den Drain-Kontakt des vertikalen Transistors an eine Bitleitung anzuschließen. Bei fortschreitender Miniaturisierung werden die Anforderungen an diese beiden Anschlüsse bezüglich der Justiergenauigkeit weiter steigen.

Es ist die Aufgabe der Erfindung eine verbesserte Speicherzelle mit einem Graben und einer epitaktisch aufgewachsenen Schicht bereitzustellen, die den Herstellungsprozessen erhöhte Justagetoleranzen einräumt. Außerdem ist es die Aufgabe der Erfindung ein Verfahren zu ihrer Herstellung anzugeben.

Erfindungsgemäß wird die angegebene Aufgabe durch eine Speicherzelle gelöst, die folgende Merkmale umfasst: ein Substrat; einen Graben, der einen unteren Bereich, einen mittleren Bereich, einen oberen Bereich und eine Innenwand aufweist und in dem Substrat angeordnet ist; einen Isolationskragen in dem mittleren Bereich, an der Innenwand des Grabens angeordnet ist; eine dielektrische Schicht, die mindestens in dem unteren Bereich des Grabens angeordnet ist; einer leitenden Grabenfüllung, die den unteren Bereich und den mittleren Bereich des Grabens zumindest teilweise auffüllt; eine epitaktisch aufgewachsene Schicht, die in dem oberen Bereich des Grabens an der Innenwand des Grabens und auf der leitenden Grabenfüllung angeordnet ist; und sich dadurch auszeichnet, dass in dem oberen Bereich des Grabens, oberhalb der epitaktisch aufgewachsenen Schicht eine zweite dielektrische Schicht mit einer Innenöffnung angeordnet ist.

Der Kanal des vertikalen Transistors wird dabei in der epitaktisch aufgewachsenen Schicht gebildet und mit einem Gate-Oxid versehen. Das Gate-Material befindet sich auf dem Gate-Oxid.

Der Vorteil der zweiten dielektrischen Schicht besteht darin, dass mit ihrer Hilfe der Gate-Anschluß von der Wortleitung an das Gate-Material des vertikalen Transistors selbstjustiert gebildet werden kann.

Dabei dient die zweite dielektrische Schicht als Maske für die Freiätzung des Gate-Materials bei der Verbindung zur Wortleitung. Dies hat den Vorteil, dass lediglich wesentlich größere Justagetoleranzen eingehalten werden müssen, was die Möglichkeit bietet, den Miniaturisierungsprozeß weiter voranzutreiben.

Ein weiterer Vorteil ist, dass der Graben zur effizienteren Ausnutzung der vorhandenen Fläche breiter als die Kontakte und breiter als die Wortleitung ausgebildet werden kann, da der Ätzprozeß automatisch die Innenöffnung in der zweiten dielektrischen Schicht freiätzt. Damit sind geringere Sicherheitsvorhalte und ein platzsparenderes Wortleitungs-Layout möglich.

Weiterhin wird die gestellte Aufgabe durch ein Verfahren zur Herstellung einer Speicherzelle mit den Schritten:
- Bilden eines Grabens in einem Substrat, der einen unteren Bereich, einen mittleren Bereich, einen oberen Bereich und eine Innenwand aufweist;
- nachfolgend Bilden eines Isolationskragens in dem mittleren Bereich, an der Innenwand des Grabens;
- anschließend Bilden einer dielektrischen Schicht, mindestens in dem unteren Bereich des Grabens;
- anschließendes Bilden einer leitenden Grabenfüllung in dem unteren Bereich des Grabens auf der dielektrischen Schicht und mindestens teilweise in dem mittleren Bereich des Grabens auf dem Isolationskragen;
- nachfolgend Epitaktisches Aufwachsen einer Schicht in dem oberen Bereich des Grabens an der Innenwand des Grabens und auf der leitenden Grabenfüllung,
- wobei eine zweite dielektrischen Schicht mit einer Innenöffnung in dem oberen Bereich des Grabens oberhalb der epitaktisch aufgewachsenen Schicht gebildet wird.

In einer vorteilhaften Ausbildung der Erfindung ist auf der epitaktisch aufgewachsenen Schicht unterhalb der zweiten dielektrischen Schicht eine dritte dielektrische Schicht angeordnet. In dieser Anordnung ist die dritte dielektrische Schicht ein Gate-Oxid. Vorteilhaft ist dabei, dass das Gate-Oxid auf der epitaktisch aufgewachsenen Schicht entsteht und den Kanal von einem Gate-Material isoliert. Die Öffnung in der zweiten dielektrischen Schicht ist dabei kleiner als der Durchmesser des Gate-Materials.

Weiterhin ist es vorteilhaft, dass ein Isolationsgraben so angeordnet ist, dass er die Speicherzelle und eine benachbarte Speicherzelle umgibt und zwischen der Speicherzelle und der benachbarten Speicherzelle ein aktives Gebiet ausgebildet wird, das dotiert ist. Durch diese Anordnung werden zwei benachbarte Speicherzellen mit einem aktiven Gebiet verbunden, auf dem später der Bitleitungskontakt gebildet werden kann.

Weiterhin ist es vorteilhaft, dass das Kanalgebiet des vertikalen Transistors nicht isoliert ist, wie es bei einem SOI-Transistor (Silicon on insulator) der Fall wäre. Durch den Bulk-Anschluß wird das Steuerverhalten des vertikalen Transistors verbessert und er kann durch eine geeignete Gate-Spannung wieder in den Sperrzustand versetzt werden. Weiterhin hat der Isolationsgraben die Aufgabe, die Speicherzelle und die benachbarte Speicherzelle gegen die übrigen Speicherzellen zu isolieren, was Leckströme verringert und vermeidet.

Eine weitere vorteilhafte Ausbildung der Erfindung sieht vor, dass die epitaktisch aufgewachsene Schicht ein unteres dotiertes Gebiet, das an die leitende Grabenfüllung angeschlossen ist und ein oberes dotiertes Gebiet, das an das aktive Gebiet angeschlossen ist, aufweist. Die dotierten Gebiete stellen das Source-Gebiet und das Drain-Gebiet des vertikalen Transistors dar.

Eine vorteilhafte Ausführung der Erfindung sieht vor, dass eine Bitleitung über das aktive Gebiet verläuft und das aktive Gebiet kontaktiert. Die Bitleitung wir dabei streckenweise über dem Isolationsgraben und streckenweise über das aktive Gebiet geführt, welches dadurch kontaktiert wird. Die Bitleitung weist durch diese Anordnung eine niedrige Leitungskapazität auf, was besonders vorteilhaft bei dem Auslesen einer Speicherzelle ist, da beim Auslesen das Verhältnis aus Bitleitungskapazität zu Speicherzellenkapazität möglichst klein sein sollte, damit die in der Speicherzelle gespeicherte Ladung in der Lage ist, die Bitleitung umzuladen. Weiterhin kann die Bitleitung aus einem niederohmigen Material gebildet werden, wodurch die Speicherzelle schnell wird.

Eine weitere vorteilhafte Ausführung der Erfindung besteht in der Einkapselung der Bitleitung in einer dielektrischen Hülle. Die dielektrische Hülle kann bei der Ätzung des Kontaktlochs für den Gate-Anschluß als selbstjustierende Ätzmaske verwendet werden und so die Justagetoleranz der Speicherzelle verbessern.

Eine weitere vorteilhafte Ausprägung der Erfindung sieht vor, das ein Gate-Material auf der dritten dielektrischen Schicht angeordnet ist und zumindest bis an die Innenöffnung der zweiten dielektrischen Schicht heranreicht. Weiterhin ist vorgesehen, dass ein Gate-Anschluß auf dem Gate-Material angeordnet ist und sich durch die Innenöffnung der zweiten dielektrischen Schicht und durch eine Glasschicht bis zu einer Wortleitung erstreckt, die auf der Glasschicht angeordnet sein kann. Durch diese Anordnung ist gewährleistet, dass das Gate-Material durch die Innenöffnung der zweiten dielektrischen Schicht an eine Wortleitung angeschlossen ist. Weiterhin ist es in vorteilhafter Weise möglich, den Gate-Anschluß selbstjustiert zu bilden.

Eine weitere vorteilhafte Ausprägung der Erfindung sieht vor, dass die Wortleitung oberhalb der Bitleitung verläuft. Durch diese Anordnung ist eine niedrige Koppelkapazität zwischen Bitleitung und Wortleitung möglich, was sich vorteilhaft beim Auslesen einer Speicherzelle durch geringes Übersprechen von der Wortleitung auf die Bitleitung bemerkbar macht. Weiterhin ist dadurch die Gesamtbitleitungskapazität durch verringert, was die Geschwindigkeit der Speicherzelle steigert und die Auslesesicherheit erhöht.

Eine weitere vorteilhafte Ausprägung der Erfindung sieht vor, das eine Schaltungsperipherie Transistoren mit Gate-Elektroden aufweist und die Gate-Elektroden in einem Prozeßschritt mit der Bitleitung gebildet werden. Durch die Kombination von Herstellungsschritten in der Schaltungsperipherie, welche die Ansteuerlogik für das Speicherzellenfeld beinhaltet, mit Herstellungsschritten für Schichten und Strukturen im Zellenfeld können die Herstellungskosten für einen Speicher gesenkt werden. Daher ist es sehr effektiv, die Gate-Elektroden der Transistoren der Schaltungsperipherie in einem Schritt mit der Bitleitung in dem Zellenfeld herzustellen.

Eine weitere vorteilhafte Anordnung der Speicherzelle sieht vor, dass neben dem Graben weitere Gräben in einem größtenteils hexagonalen Muster angeordnet sind. Diese Anordnung hat den Vorteil, dass die zur Verfügung stehende Oberfläche optimal ausgenutzt werden kann, da eine hexagonale Anordnung der Gräben die größte Packungsdichte in einer zweidimensionalen Anordnung darstellt. Dadurch kann jeder einzelne Graben so angeordnet werden, dass sein Abstand zu seinen nächsten benachbarten Graben gleichmäßig ist.

Weitere Ausgestaltungen der Erfindung sind Gegenstand der jeweiligen Unteransprüche.

Die Erfindung wird nachfolgend an einem Ausführungsbeispiel anhand von Figuren näher erläutert.

### In den Figuren zeigen:

- Figur 1: einen Grabenkondensator;
- Figur 2 bis Figur 12: aufeinander folgende Herstellungsschritte eines Grabenkondensators nach Figur 1;
- Figur 13: ein Schnittbild entlang der Schnittlinie A aus Figur 25 zu einem Prozeßzeitpunkt, der nach Figur 12 folgt;
- Figur 14 bis Figur 19: aufeinander folgende Herstellungsschritte eines Grabenkondensators nach Figur 12;
- Figur 20: Draufsicht auf eine Anordnung von Gräben;
- Figur 21: Draufsicht auf eine Anordnung von aktiven Gebieten;
- Figur 22: Draufsicht auf eine Anordnung von Bitleitungen;
- Figur 23: Draufsicht auf eine Anordnung von Speicherzellen;
- Figur 24: Draufsicht auf eine weitere Anordnung von Bitleitungen;
- Figur 25: Draufsicht auf eine Anordnung von Speicherzellen.
- Figur 26: Draufsicht auf eine Anordnung von Wortleitungen.

In den Figuren bezeichnen gleiche Bezugszeichen gleiche oder funktionsgleiche Elemente.

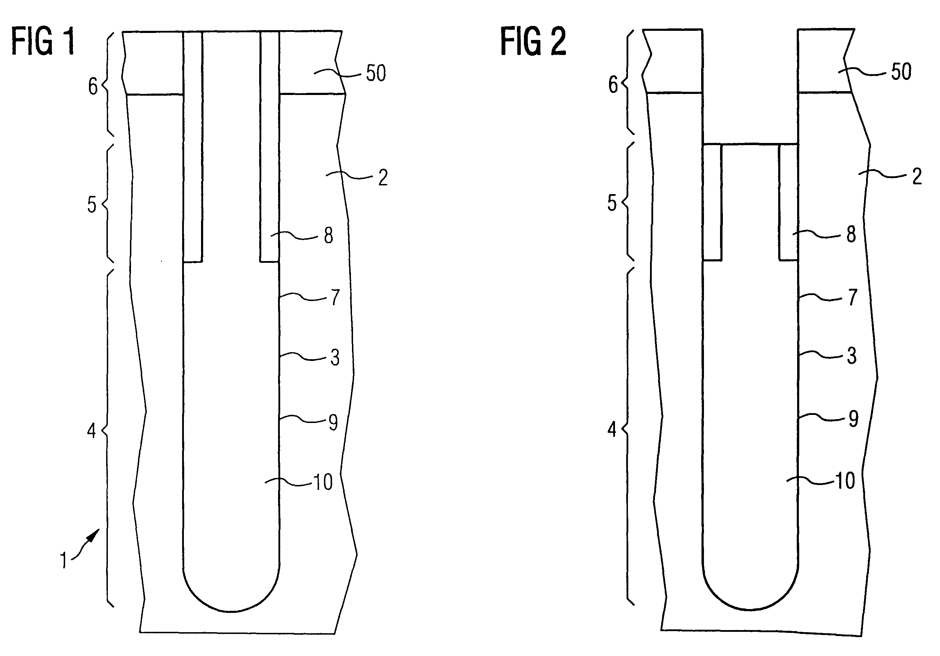

In Figur 1 ist eine Speicherzelle 1 dargestellt, die einen Graben 3 umfaßt, der in einem Substrat 2 gebildet ist. Das Substrat 1 besteht in diesem Ausführungsbeispiel aus Silizium, das mit Bor, Phosphor oder Arsen dotiert sein kann. Der Graben 3 weist dabei einen unteren Bereich 4, einen mittleren Bereich 5 und einen oberen Bereich 6 auf. Weiterhin weist der Graben 3 eine Innenwand 7 auf. In dem mittleren Bereich 5 und dem oberen Bereich 6 des Grabens 3 ist auf der Innenwand 7 ein Isolationskragen 8 angeordnet. Der Isolationskragen besteht üblicherweise aus Siliziumoxid. Weiterhin befindet sich auf dem Substrat 2 eine Hartmaske 50, die als Ätzmaske für die Ätzung des Grabens 3 dient. Die Hartmaske 50 ist beispielsweise aus Siliziumnitrid gebildet. Die Innenwand 7 des Grabens 3 ist im unteren Bereich 4 mit einer dielektrischen Schicht 9 ausgekleidet. Weiterhin kann sich die dielektrische Schicht 9 optional in dem mittleren Bereich 5 in dem oberen Bereich 6 auf dem Isolationskragen 8 oder unter dem Isolationskragen 8, d.h. auf der Grabeninnenwand 7 befinden. Zusätzlich ist der Graben 3 mit einer leitenden Grabenfüllung 10 gefüllt. Die leitende Grabenfüllung besteht beispielsweise aus dotiertem Silizium. Die leitende Grabenfüllung 10 dient als innere Kondensatorelektrode, das außenliegende Substrat 2 als äußere Kondensatorelektrode. Das Kondensatordielektrikum wird von der dielektrischen Schicht 9 gebildet.

Ein Herstellungsverfahren zur Bildung der in Figur 1 dargestellten Speicherzelle besteht in dem Abscheiden einer Hartmaske 50, die üblicherweise aus Siliziumnitrid gebildet wird. Zur Herstellung der Hartmaske 50 wird beispielsweise ein LPCVD- (low pressure chemical vapor deposition) Verfahren verwendet. Die Hartmaske 50 wird anschließend strukturiert und als Ätzmaske für die Ätzung des Grabens 3 verwendet. Nach dem Ätzen des Grabens 3 wird dieser mit einer dielektrischen Schicht 9 verkleidet. Die dielektrische Schicht besteht üblicherweise aus einem Siliziumoxid, Siliziumnitrid oder aus einer Kombination aus beidem, wie einem Oxynitrid, welches durch thermische und durch CVD-Verfahren gebildet wird. In einem folgenden Verfahrensschritt wird der Isolationskragen 8 in dem mittleren und oberen Bereich 5, 6 des Grabens 3 gebildet.

Üblicherweise ist das Substrat 2 aus einkristallinen Silizium gebildet. Der Isolationskragen 8 ist aus einem Siliziumoxid gebildet, das üblicherweise in einem CVD-Prozeß aufgebracht wird. Die leitende Grabenfüllung 10 besteht in diesem Ausführungsbeispiel aus einem hochdotiertem Polysilizium und wird üblicherweise ebenfalls durch einen CVD-Prozeß in den Graben gefüllt.

Mit Bezug auf Figur 2 werden die leitende Grabenfüllung 10 und der Isolationskragen 8 eingesenkt, so dass sie aus dem oberen Bereich 6 des Grabens 3 entfernt werden. Falls optional vorhanden, wie im Ausführungsbeispiel gezeigt, bleibt die dielektrische Schicht 9 zunächst in dem oberen Bereich 6 des Grabens 3 stehen, da der Einsenkprozeß, der die leitende Grabenfüllung 10 und den Isolationskragen 8 einsenkt selektiv gegenüber der nitridhaltigen dielektrische Schicht 9 ist.

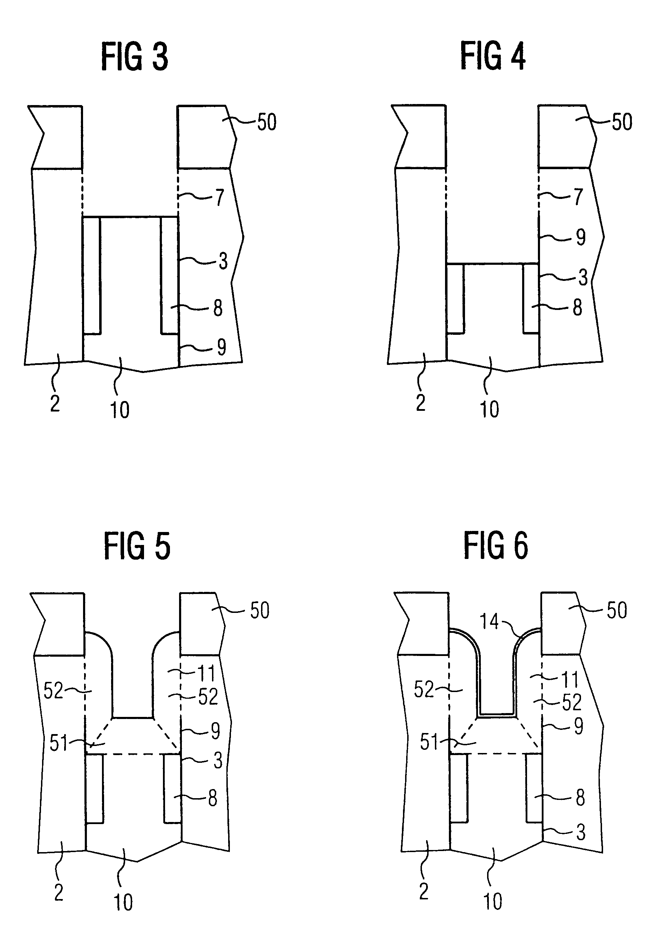

Mit Bezug auf Figur 3 wird in einem folgenden Schritt die optional vorhandene dielektrische Schicht 9 aus dem oberen Bereich 6 des Grabens 3 entfernt. Durch diesen Verfahrensschritt wird das Substrat 2 in dem oberen Bereich 6 des Grabens 3 an der Innenwand 7 freigelegt.

Mit Bezug auf Figur 4 wird ein weiterer Einsenkprozeß optional ganz oder teilweise durchgeführt, bei dem die leitende Grabenfüllung 10 und der Isolationskragen 8 aus dem oberen Bereich 6 und dem mittleren Bereich 5 des Grabens 3 partiell entfernt werden. Wiederum bleibt, falls vorhanden, die dielektrische Schicht 9 an der Grabeninnenwand 7 in dem oberen Bereich 6 und dem mittleren Bereich 5 stehen, da die leitende Grabenfüllung 10 und der Isolationskragen 8 selektiv gegenüber der dielektrischen Schicht 9 entfernt werden.

Mit Bezug auf Figur 5 wird eine epitaktisch aufgewachsene Schicht 11 in einem Epitaxieschritt in dem oberen Bereich 5 und im mittleren Bereich 6 des Grabens 3 aufgewachsen. Dabei wächst das epitaktisch aufgewachsene Silizium auf bereits vorhandenem Silizium an. Hierbei gibt es zwei Wachstumszonen, wobei es sich bei der einen Wachstumszone um eine polykristalline epitaktische Schicht 51 handelt, die auf der leitenden Grabenfüllung 10 aufwächst und bei der anderen epitaktisch aufgewachsenen Schicht um einen einkristallin aufgewachsenen Ring 52, der auf der Innenwand 7 des Grabens 3 aufwächst. Optional ist eine Dotierung zur Einstellung der Schwellspannung des Transistors im Kanalbereich vorgesehen. Desweiteren kann optional das Loch, welches durch das epitaktisch aufgewachsene Silizium in dem Graben 3 gebildet wird, in dem unteren Bereich 4 durch ein CVD-Oxid bis zu der Höhe der späteren Ausdiffusion des unteren Dotiergebiets 18 aufgefüllt werden um die Transistorkapazität zum Gate zu reduzieren.

Mit Bezug auf Figur 6 wird eine dritte dielektrische Schicht 14 auf der epitaktisch aufgewachsenen Schicht 11 gebildet. Die dritte dielektrische Schicht 14 dient später als Gate-Oxid.

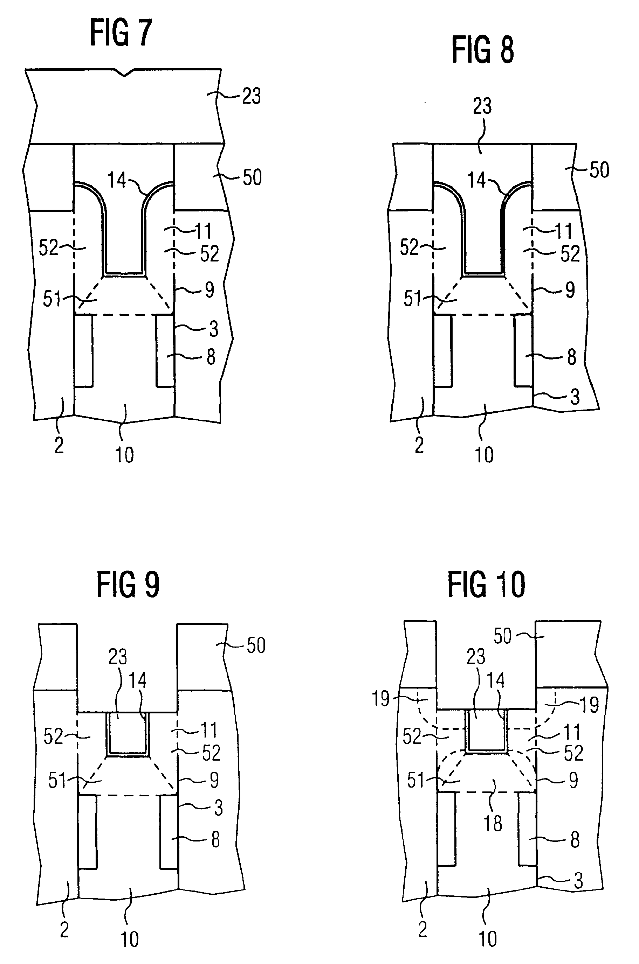

Mit Bezug auf Figur 7 wird ein Gate-Material 23 auf der Substratoberfläche gebildet. Bei dem Gate-Material 23 handelt es sich üblicherweise um hochdotiertes, polykristallines Silizium. In einem anschließenden CMP-Prozeß (chemical mechanical polishing) wird das Gate-Material 23 von der Oberfläche des Substrats entfernt und verbleibt lediglich in dem Graben 3 oberhalb der dritten dielektrischen Schicht 14.

Mit Bezug auf Figur 9 wird ein weiterer Einsenkprozeß durchgeführt, bei dem das Gate-Material 23, die dritte dielektrische Schicht 14 und die epitaktisch aufgewachsene Schicht 11 teilweise aus dem oberen Bereich 6 des Grabens 3 entfernt werden.

Mit Bezug auf Figur 10 wird in einem Dotierprozeß Dotierstoff in den oberen Bereich des Grabens 3 und in das angrenzende Substrat 2 eingebracht. Das obere Dotiergebiet 19 wird mittels eingebrachten Dotierstoff gebildet. Die Dotierung kann beispielsweise mittels Gasphasendotierung und anschließender Ausdiffusion durchgeführt werden. Bei der anschließenden Ausdiffusion in einem Temperaturschritt, der optional oxidierend ist, diffundiert ebenfalls Dotierstoff aus der leitenden Grabenfüllung 10 in die epitaktisch aufgewachsene Schicht 11 und bildet dabei ein unteres Dotiergebiet 18.

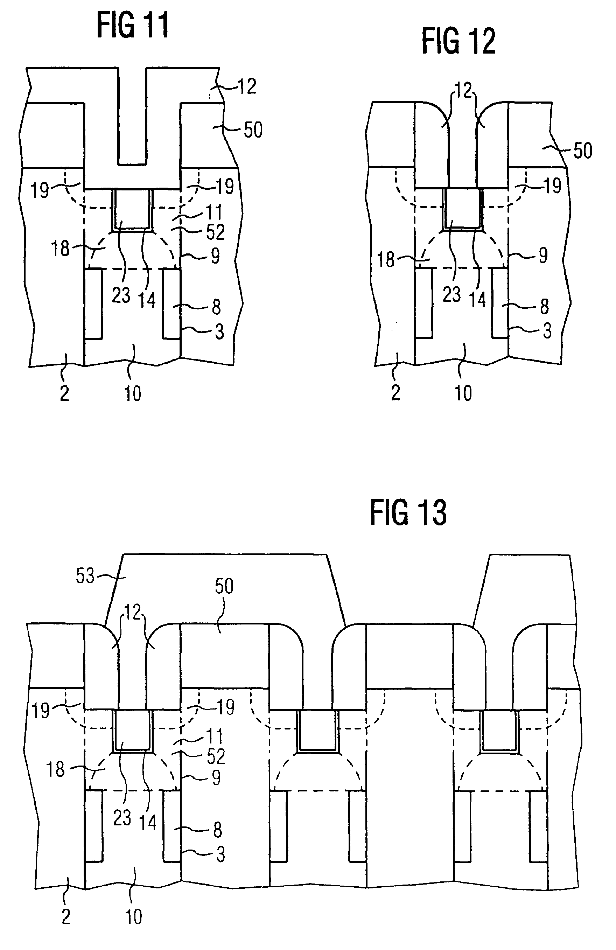

Mit Bezug auf Figur 11 wird eine zweite dielektrische Schicht 12 auf das Substrat abgeschieden. Bei der zweiten dielektrischen Schicht 12 handelt es sich beispielsweise um eine mittels CVD-Prozess aufgebrachte Siliziumnitridschicht. Die zweite dielektrische Schicht ist dabei dicker als die durch Epitaxie aufgewachsene Schicht 11.

Mit Bezug auf Figur 12 wird eine anisotrope Siliziumnitridätzung durchgeführt, so dass die zweite dielektrische Schicht 12 von der Hartmaske 50 entfernt wird und lediglich als seitlicher Randsteg (spacer) in dem oberen Bereich 6 des Grabens 3 verbleibt. Die zweite dielektrische Schicht 12 weist dabei eine Innenöffnung 13 auf.

Mit Bezug auf Figur 13 wird eine Maske 53 auf dem Substrat abgeschieden und strukturiert, so dass Teile der darunterliegenden Struktur freigelegt werden. Die Maske 53 ist dabei so plaziert, dass sie ein zu bildendes aktives Gebiet 17 abdeckt und die Bereiche der Oberfläche freigibt, in denen der Isolationsgraben 15 zu bilden ist. Besonders vorteilhaft ist es dabei, die Öffnung in der Maske 53 so zu wählen, dass jeweils zwei benachbarte zweite dielektrische Schichten 12 zumindest teilweise freigelegt werden. Der Vorteil liegt darin, dass als Justiertoleranz die Breite des seitlichen Abstandssteges der zweiten dielektrischen Schicht 12 zur Verfügung steht. Weitere Justagetoleranz für die Ausbildung der aktiven Gebiete wird durch vorheriges Füllen der Innenöffnung 13 mit planarisierendem Material. Nach dem Öffnen der dünnen Deckschicht mit der Maske 53 kann die nachfolgende Nitridätzung selektiv zu dem planarisierendem Material ausgeführt werden. Als Material eignet sich zum Beispiel eine Antireflexschicht (ARC). Dadurch steht die Fläche der gesamten Grabenöffnung als Justagetoleranz zur Verfügung.

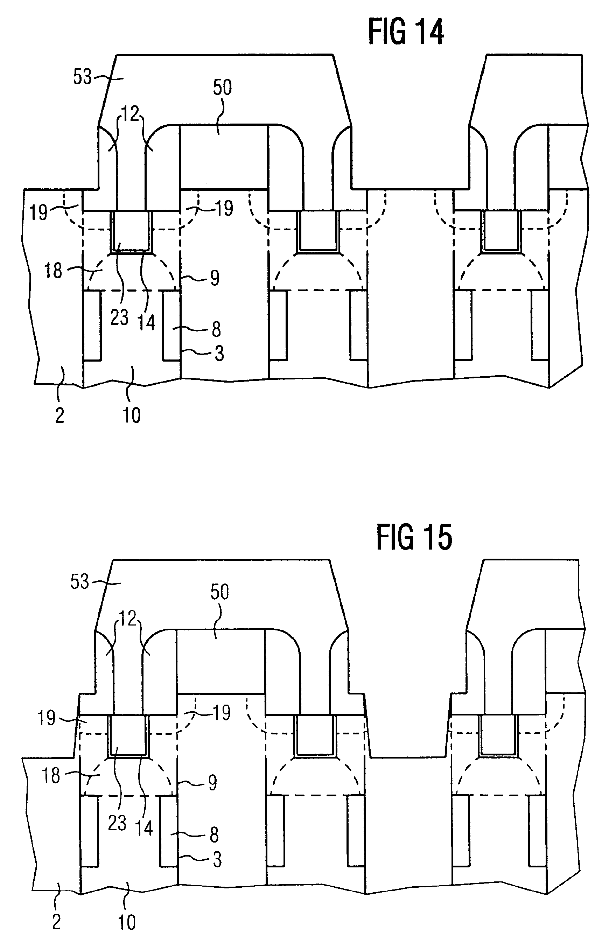

Mit Bezug auf Figur 14 wird ein erster Ätzschritt zur Bildung des Isolationsgrabens durchgeführt. Mit Bezug auf Figur 15 wird ein zweiter Ätzschritt zur Bildung der Isolationsgräben durchgeführt, wobei dieser Ätzprozeß selektiv zu dem Material der zweiten dielektrischen Schicht 12, die in diesem Fall aus Siliziumnitrid gebildet ist, durchgeführt wird. Durch dieses Verfahren wird sichergestellt, dass der Isolationsgraben 15 selbstjustiert zwischen benachbarten Gräben gebildet wird.

In einem nachfolgenden Prozeß wird die Maske 53 von der Substratoberfläche und optional das planarisierende Material aus der Öffnung 13 entfernt, eine thermische Oxidierung der geöffneten Isolationsgräben durchgeführt und anschließend ein Oxid zum Beispiel durch ein HDP-Oxid (high density pressure oxid) abgeschieden, welches die Isolationsgräben 15 bildet und die Oxidfüllung 54 in der Innenöffnung 13 der zweiten dielektrischen Schicht 12 bildet. Anschließend wird die Oberfläche mit einem CMP-Prozeß planarisiert.

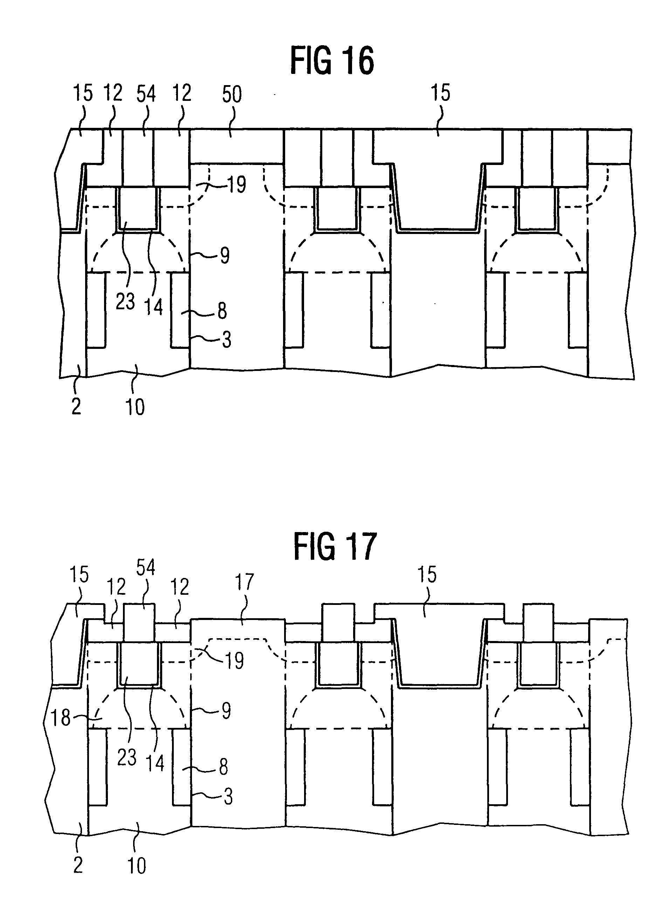

Mit Bezug auf Figur 17 wird die zweite dielektrische Schicht 12 eingesenkt und die Hartmaske 50 von der Substratoberfläche entfernt. Dieses kann in einem Schritt durchgeführt werden, da die Hartmaske 50 und die zweite dielektrische Schicht 12 aus Siliziumnitrid bestehen, welches mittels heißer Phosphorsäure selektiv geätzt werden kann. Anschließend wird eine Opferoxidschicht thermisch aufgewachsen, die bei einer anschließenden Implantation des aktiven Gebiets 17 als Streuoxid dient. Ebenfalls ist eine Dotierung mittels Gasphasendotierung oder Plasma Ionen Immersions Implantation möglich. Nach der Dotierung wird das Opferoxid entfernt und die Oberfläche des aktiven Gebiets 17 kann optional gereinigt werden, indem ein weiteres thermisches Oxid aufgewachsen und mittels Flußsäure entfernt wird.

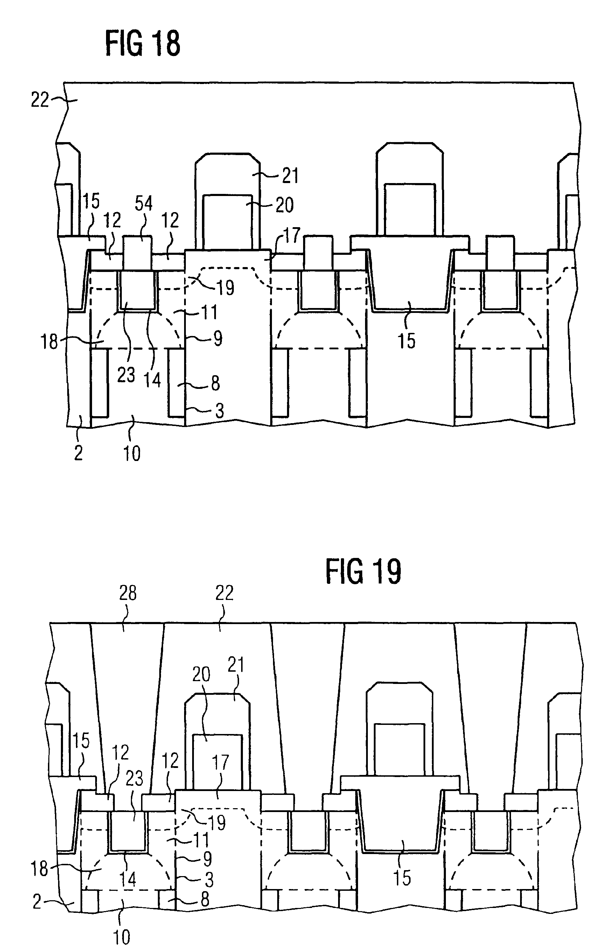

Mit Bezug auf Figur 18 wird eine Bitleitung 20 auf der Substratoberfläche gebildet, so dass die Bitleitung 20 teilweise auf dem Isolationsgraben 15 und teilweise auf dem aktiven Gebiet 17 verläuft. Mit der Bitleitung 20 wird das aktive Gebiet 17 und damit das obere dotierte Gebiet 19 an die Bitleitung angeschlossen. Anschließend wird eine dielektrische Hülle 21 um die Bitleitung 20 gebildet, um diese zu isolieren. Weiterhin wird eine Glasschicht 22 auf dem Substrat 2 gebildet, die üblicherweise aus einem hochdotierten Silikatglas besteht. Unter die Glasschicht 22 kann optional eine nitridhaltige CVD-Schicht abgeschieden werden, die als Diffusionssperre zum Substrat dient. Die Glasschicht 22 dient zur Planarisierung, da das hochdotierte Silikatglas bei einem Temperaturschritt verfließt.

Mit Bezug auf Figur 19 werden in einem photolithographischen Schritt eine Maske für die Ätzung der Wortleitungen und des Kontaktlochs für den Gate-Anschluß strukturiert. Der nachfolgende Ätzprozeß ätzt das dotierte Silikatglas in dem von der Maske freigelegten Bereich und ist selektiv gegenüber Siliziumnitrid, so dass der Gate-Anschluß 28 selbstjustiert zwischen den Bitleitungen 21 gebildet wird und die Innenöffnung der zweiten dielektrischen Schicht 12 automatisch freilegt. Bei diesem Ätzschritt wird das Gate-Material 23 freigelegt. Mittels eines leitenden Materials 28 wird das Gate-Material mit der dabei gebildeten Wortleitung 24 angeschlossen.

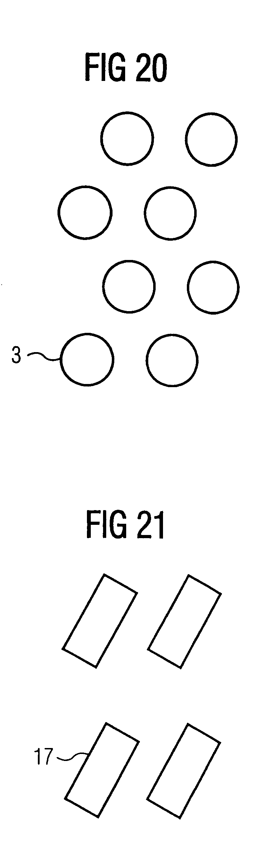

In Figur 20 ist die hexagonale Anordnung von Speichergräben gezeigt. Ebenfalls ist der Graben 3 dargestellt.

In Figur 21 ist Maske zur Ausbildung der aktiven Gebiete dargestellt und ein aktives Gebiet 17 markiert.

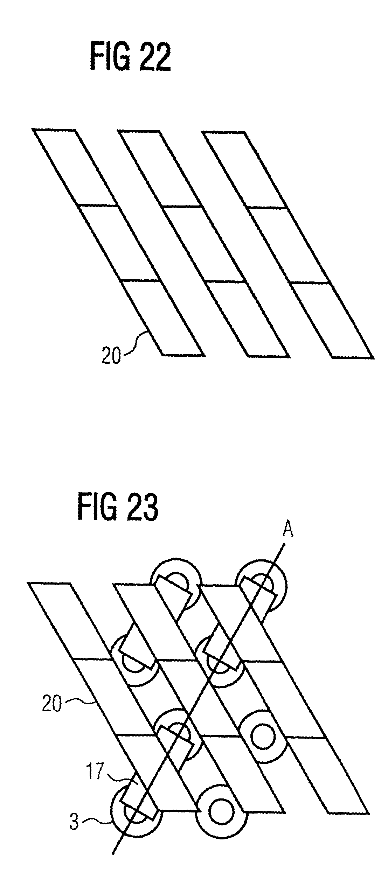

In Figur 22 ist ein erster Verlauf von Bitleitungen dargestellt, wobei die Bitleitung 20 parallel zu den übrigen Bitleitungen verläuft.

In Figur 23 ist die Kombination der Figuren 20, 21 und 22 mit unterschiedlichen Überlagerungen zur besseren Kenntlichmachung der Kantenlage dargestellt, wobei jeweils zwei Gräben durch ein aktives Gebiet 17 verbunden werden und die Bitleitung 20 teilweise über das aktive Gebiet 17 und teilweise über den Isolationsgraben 15 verläuft.

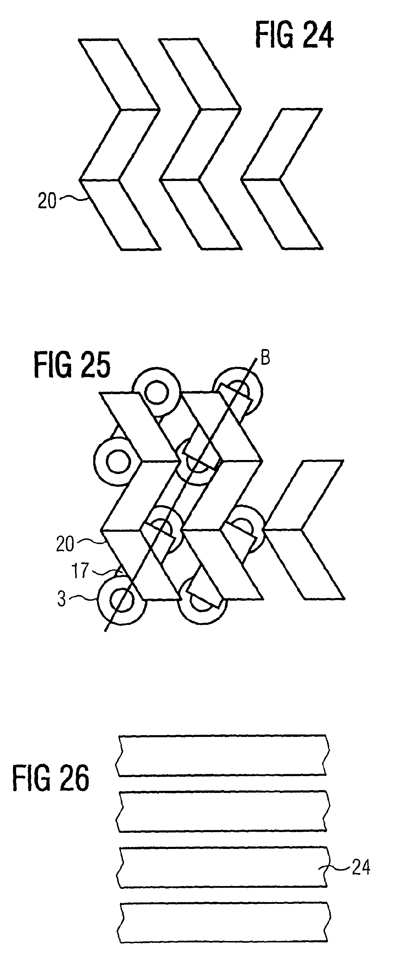

In Figur 24 ist ein weiteres Ausführungsbeispiel einer Bitleitungsanordnung gezeigt, wobei die Bitleitung 20 im Zick-Zack-Muster angeordnet ist.

Mit Bezug auf Figur 25 ist die Kombination der Figuren 20, 21 und 24 dargestellt. Der Graben 3 ist mit dem aktiven Gebiet 17 an einen benachbarten Graben angeschlossen und wird von dem Isolationsgraben 15 umgeben. Weiterhin ist der Verlauf der Bitleitung 20 dargestellt, die wiederum teilweise über das aktive Gebiet 17 und über den Isolationsgraben 15 verläuft. Weiterhin ist in Figur 23 eine Schnittlinie A dargestellt, welche die aktiven Gebiete 17 in Längsrichtung schneidet.

In Figur 26 ist der Verlauf der Wortleitungen dargestellt.

Ein Vorteil der Erfindung ist, dass in dem Graben 3 über dem vertikalen Transistor ein Siliziumnitriddeckel mit einer Innenöffnung 13 hergestellt wird. Zur Verdeutlichung der Lage sind jeweils in Figur 23 und 25 die Innenöffnung 13 in einigen Gräben beispielhaft gezeichnet. Da die Bitleitungen beispielsweise mit einem Nitrid 13 ummantelt sind, ist es möglich, bei der Ausbildung der Wortleitung 28 zwischen den Bitleitungen und durch die Innenöffnung 13 selbstjustiert den Kontakt zum Gate-Material 23 zu bilden. Weiterhin ist es erfindungsgemäß vorteilhaft, den Graben 3 nicht unter der Kreuzung aus Wortleitung und Bitleitung anzuordnen, sondern leicht versetzt dazu.

Ein besonderer Vorteil des erfindungsgemäßen Verfahrens besteht in der großen Justagetoleranz, die durch den selbstjustierten Prozeß der Gate-Anschlußherstellung ermöglicht wird.

Dadurch ist es möglich, die Wortleitung mit einer geringeren Breite als den Graben 3 auszubilden und trotzdem die gesamte dritte dielektrische Schicht, welche als Gate-Oxid verwendet wird zu kontaktieren.

Ein weiterer Vorteil der Erfindung besteht darin, dass die Innenöffnung 13 selbstjustiert von oben geöffnet und der Gate-Anschluß 28 selbstjustiert kontaktiert wird. Dadurch ist es möglich, den Graben mit einem größeren Durchmesser als der minimalen Strukturbreite auszuführen um damit die Kapazität des Grabens zu vergrößern.

Ein weiterer Vorteil des erfindungsgemäßen Verfahrens besteht darin, dass das Gate-Oxid nicht aus dem Graben 3 herauswächst, sondern lediglich auf der epitaktisch aufgewachsenen Schicht 11 in dem Graben 3 gebildet wird. Ein weiterer Vorteil des erfindungsgemäßen Verfahrens besteht darin, dass das obere dotierte Gebiet 19 an das aktive Gebiet 17 angeschlossen wird. Weiterhin verläuft die Bitleitung 20 auf dem aktiven Gebiet 17 und schließt dieses an.

Ein weiterer Vorteil des erfindungsgemäßen Verfahrens ist es, die Bitleitung mit einer Isolationshülle zu umgeben. Besonders vorteilhaft ist es dabei, die dielektrische Hülle 21 aus Siliziumnitrid zu bilden, da dieses als Ätzmaske bei nachfolgenden Oxidstrukturierungen verwendet werden kann.

Ein weiterer Vorteil des erfindungsgemäßen Vorgehens ist es, die Wortleitung in der Peripherie in ein und dem selben Verfahrensschritt wie die Bitleitung im Zellenfeld zu bilden. Dadurch ist es möglich, Kosten bei der Herstellung eines Speicherbausteins zu sparen.

Ein weiterer Vorteil des erfindungsgemäßen Verfahrens bildet die Wortleitung 24 oberhalb der Bitleitung 20, wodurch die Koppelkapazität zwischen Wortleitung und Bitleitung gering gehalten wird und ebenfalls die Gesamtkapazität der Bitleitung gering ist, was ein sicheres Auslesen der Speicherzelle ermöglicht.

Weiterhin ist es vorteilhaft, die Speichergräben 3 in einer hexagonalen Anordnung vorzusehen, wodurch die Substratoberfläche optimal ausgenutzt wird und die Kapazität des Grabenkondensators erhöht wird.

Optional kann eine vergrabene Platte (burried plate) als Gegenelektrode des Grabenkondensators vorgesehen werden. Dazu wird beispielsweise bei der Bildung des Grabenkondensators Dotierstoff aus dem mit einem dotierten Material gefüllten Graben in das Substrat diffundiert. Weiterhin kann eine vergrabene Wanne vorgesehen werden (burried layer), die die vergrabenen Platten benachbarter Grabenkondensatoren verbindet.

## Patentansprüche

1. Speicherzelle mit:
- einem Substrat (2);
- einem Graben (3), der einen unteren Bereich (4), einen mittleren Bereich (5), einen oberen Bereich (6), und eine Innenwand (7) aufweist und in dem Substrat (2) angeordnet ist;
- einem Isolationskragen (8), der in dem mittleren Bereich (5) an der Innenwand (7) des Grabens (3) angeordnet ist;
- einer dielektrischen Schicht (9), die mindestens in dem unteren Bereich (4) des Grabens (3) angeordnet ist;
- einer leitenden Grabenfüllung (10), die den unteren Bereich (4) und den mittleren Bereich (5) des Grabens (3) zumindest teilweise auffüllt;
- einer epitaktisch aufgewachsenen Schicht (11), die in dem oberen Bereich (6) des Grabens (3) an der Innenwand (7) des Grabens (3) und auf der leitenden Grabenfüllung (10) angeordnet ist,
- wobei ein Isolationsgraben (15) so angeordnet ist, dass er die Speicherzelle (1) und eine benachbarte Speicherzelle (16) umgibt und zwischen der Speicherzelle (1) und der benachbarten Speicherzelle (16) ein aktives Gebiet (17) ausgebildet ist, welches dotiert ist und
- in dem oberen Bereich (6) des Grabens (3) oberhalb der epitaktisch aufgewachsenen Schicht (11) eine zweite dielektrische Schicht (12) mit einer Innenöffnung (13) angeordnet ist.

2. Speicherzelle nach Anspruch 1,
**dadurch gekennzeichnet, dass**
auf der epitaktisch aufgewachsenen Schicht (11) unterhalb der zweiten dielektrischen Schicht (12) eine dritte dielektrische Schicht (14) angeordnet ist.

3. Speicherzelle nach einem der Ansprüche 1 oder 2,
**dadurch gekennzeichnet, dass**
die epitaktisch aufgewachsene Schicht (11) ein unteres dotiertes Gebiet (18), das an die leitende Grabenfüllung (10) angeschlossen ist und ein oberes dotiertes Gebiet (19), das an das aktive Gebiet (17) angeschlossen ist, aufweist.

4. Speicherzelle nach einem der Ansprüche 1 bis 3,
**dadurch gekennzeichnet, dass**
eine Bitleitung (20) über das aktive Gebiet (17) verläuft und das aktive Gebiet (17) kontaktiert.

5. Speicherzelle nach Anspruch 4,
**dadurch gekennzeichnet, dass**
die Bitleitung (20) von einer dielektrischen Hülle (21) eingekapselt wird.

6. Speicherzelle nach einem der Ansprüche 1 bis 5,
**dadurch gekennzeichnet, dass**
eine Glasschicht (22) oberhalb des Substrats (1) angeordnet ist.

7. Speicherzelle nach einem der Ansprüche 2 bis 6,
**dadurch gekennzeichnet, dass**
ein Gate-Material (23) auf der dritten dielektrischen Schicht (14) angeordnet ist und zumindest bis an die Innenöffnung (13) der zweiten dielektrischen Schicht (12) heranreicht.

8. Speicherzelle nach Anspruch 7
**dadurch gekennzeichnet, dass**
ein Gate-Anschluß (28) auf dem Gate-Material (23) angeordnet ist und sich durch die Innenöffnung (13) der zweiten dielektrischen Schicht (12) und durch die Glasschicht (22) bis zu einer Wortleitung (24) erstreckt.

9. Speicherzelle nach Anspruch 8,
**dadurch gekennzeichnet, dass**
der Gate-Anschluß (28) selbstjustiert gebildet ist.

10. Speicherzelle nach Anspruch 8 oder 9,
**dadurch gekennzeichnet, dass**
die Wortleitung (24) oberhalb der Bitleitung (20) verläuft.

11. Speicherzelle nach einem der Ansprüche 1 bis 10,
**dadurch gekennzeichnet, dass**
eine Schaltungsperipherie Transistoren mit Gate-Elektroden aufweist und die Gate-Elektroden in einem Prozeßschritt mit der Bitleitung (20) gebildet werden.

12. Speicherzelle nach einem der Ansprüche 1 bis 11,
**dadurch gekennzeichnet, dass**
neben dem Graben (3) weitere Gräben in einem hexagonalen Muster angeordnet sind.

13. Verfahren zur Herstellung einer Speicherzelle (1) mit den Schritten:
- Bilden eines Grabens (3) in einem Substrat (2), der einen unteren Bereich (4), einen mittleren Bereich (5), einen oberen Bereich (6) und eine Innenwand (7) aufweist;
- nachfolgend Bilden eines Isolationskragens (8) in dem mittleren Bereich (5), an der Innenwand (7) des Grabens (3);
- anschließend Bilden einer dielektrischen Schicht (9), mindestens in dem unteren Bereich (4) des Grabens (3);
- anschließendes Bilden einer leitenden Grabenfüllung (10) in dem unteren Bereich (4) des Grabens (3) auf der dielektrischen Schicht (9) und mindestens teilweise in dem mittleren Bereich (5) des Grabens (3) auf dem Isolationskragen (8);
- nachfolgend Epitaktisches Aufwachsen einer Schicht (11) in dem oberen Bereich (6) des Grabens (3) an der Innenwand (7) des Grabens (3) und auf der leitenden Grabenfüllung (10),
**dadurch gekennzeichnet, dass**
bei dem epitaktischen Aufwachsen der Schicht (11) ein Graben in der Schicht (11) gebildet wird, der mit einem Gate-Material (23) aufgefüllt wird und nachfolgend eine zweite dielektrische Schicht (12) mit einer Innenöffnung (13) in dem oberen Bereich (6) des Grabens (3) oberhalb der epitaktisch aufgewachsenen Schicht (11) gebildet wird.

14. Verfahren nach Anspruch 13
**dadurch gekennzeichnet, dass**
auf der epitaktisch aufgewachsenen Schicht (11) unterhalb der zweiten dielektrischen Schicht (12) eine dritte dielektrische Schicht (14) gebildet wird.

15. Verfahren nach Anspruch 14,
**dadurch gekennzeichnet, dass**
auf der dritten dielektrischen Schicht (14) ein Gate-Material (23) gebildet wird, das mindestens bis zu der Innenöffnung (13) der zweiten dielektrischen Schicht (12) heranreicht.

16. Verfahren nach Anspruch 15,
**dadurch gekennzeichnet, dass**
oberhalb des Substrats (2) eine Glasschicht (22) gebildet wird und ein selbstjustierter Gate-Anschluß (28) gebildet wird, indem ein Graben in die Glasschicht (22) geätzt wird, welcher die Innenöffnung (13) der zweiten dielektrischen Schicht (12) freilegt und die zweite dielektrische Schicht (12) als Ätzmaske für die Freiätzung der Innenöffnung (13) bis zur Freilegung des Gate-Materials (23) verwendet.
